# EUROPEAN PATENT APPLICATION

(11) **EP 4 718 083 A1**
(43) Date of publication of application: **01.04.2026**
(21) Application number: 25203843.5
(22) Date of filing: 22.09.2025
(51) Int. Cl.: G01R 19/00, G01R 1/20, G01R 15/14, G01R 19/10

(54) **ULTRA HIGH COMMON MODE REJECTION RATIO HIGH SIDE CURRENT MEASUREMENT**

(30) Priority: 25.09.2024 US 202418896114
(71) Applicant: Analog Devices, Inc., Wilmington, MA 01887 (US)
(72) Inventor: NIEMANN, James Alan, Wilmington, 01887 (US)
(74) Representative: Wallin, Nicholas James

(57) **Abstract**

A measurement circuit including a power supply, a load output terminal connected to the power supply and connected to a system ground via a load, an amplifier comprising power terminals connected to the power supply, and an output terminal connected to the system ground via a measurement resistor, the amplifier is configured to supply current from the power supply to the load via the measurement resistor and the system ground producing a voltage across the measurement resistor that corresponds to the supply current through the load.

## Description

### PRIORITY CLAIM

This European patent application claims priority from United States patent application no. 18/896114, filed 25 September 2024, the entire contents of which are incorporated herein for all purposes.

### TECHNICAL FIELD

The present disclosure generally relates to a high common mode rejection ratio high side current measurement circuit. This configuration may allow for accurate current measurement in the high-side lead without introducing common-mode errors, thereby enhancing measurement accuracy and reliability in various applications.

### BACKGROUND

Current measurement techniques in electronic systems often involve measuring current in the high-side lead of a circuit. This approach is widely used in various applications, including power management, battery monitoring, and motor control. Conventional high-side current measurement systems typically employ a shunt resistor in series with the load and use differential amplifiers to measure the voltage drop across this resistor. These systems are designed to operate with both inputs of the amplifier subjected to the high common-mode voltage present on the high-side lead.

However, this conventional approach faces several challenges that can impact measurement accuracy and system performance. One significant issue is the presence of common-mode voltage errors, which can be particularly problematic when measuring currents in high-voltage applications. These errors arise from the amplifier's limited common-mode rejection ratio (CMRR) and can lead to inaccurate current measurements. Additionally, the high common-mode voltages often necessitate the use of specialized high-voltage amplifiers or complex level-shifting circuits, increasing system complexity and cost. Other challenges include limited bandwidth due to parasitic capacitances, potential safety risks associated with high voltages, and difficulties in achieving precise measurements across a wide range of current levels.

### SUMMARY

This summary is provided to introduce a selection of concepts in a simplified form that are further described below in the detailed description. This summary is not intended to identify essential features of the claimed subject matter, nor is it intended to be used as an aid in determining the scope of the claimed subject matter.

In one aspect, the present disclosure relates to a measurement circuit, comprising a power supply, a load output terminal connected to the power supply and connected to a system ground via a load, an amplifier comprising power terminals connected to the power supply, and an output terminal connected to the system ground via a measurement resistor, the amplifier is configured to supply current from the power supply to the load via the measurement resistor and the system ground producing a voltage across the measurement resistor that corresponds to the supply current through the load.

In embodiments of this aspect, the disclosure according to any one of the above example embodiments, further comprising an input supply connected to a first input terminal of the amplifier, the input supply is configured to set a voltage across the load, and a feedback loop from the load to a second input terminal of the amplifier.

In embodiments of this aspect, the disclosure according to any one of the above example embodiments, wherein the supply current flows from the power supply through the power terminals of the amplifier, through the measurement resistor to the system ground, and from the system ground through the load back to the power supply.

In embodiments of this aspect, the disclosure according to any one of the above example embodiments, wherein the amplifier is configured as a high impedance to the load output terminal and a low impedance to the measurement resistor.

In embodiments of this aspect, the disclosure according to any one of the above example embodiments, wherein the measurement resistor has a value selected to provide a desired voltage drop corresponding to an expected range of the supply current through the load.

In embodiments of this aspect, the disclosure according to any one of the above example embodiments, further comprising an additional cascaded amplifier stage comprising an additional amplifier and an additional measurement resistor, the additional measurement resistor has a different value for supplying a portion of the current to the load on a different scale from the current supplied by the measurement resistor.

In embodiments of this aspect, the disclosure according to any one of the above example embodiments, further comprising a parallel connection between the additional cascaded amplifier stage and the amplifier to increase load current capacity.

In one aspect, the present disclosure relates to a method for measuring load current, comprising receiving, by an amplifier, an input voltage for setting a load voltage of a load, the load comprising an output terminal connected to a power supply and connected to a system ground via the load, and in response to the input voltage, supplying, by the amplifier, current from the power supply to the load via power terminals of the amplifier and a measurement resistor connected to the system ground, the supply current producing a voltage across the measurement resistor that corresponds to the supply current through the load.

In embodiments of this aspect, the disclosure according to any one of the above example embodiments, further comprising feeding, via a feedback loop, a feedback signal from the load to the amplifier.

In embodiments of this aspect, the disclosure according to any one of the above example embodiments, further comprising flowing the supply current from the power supply through the power terminals of the amplifier, through the measurement resistor to the system ground, and from the system ground through the load back to the power supply.

In embodiments of this aspect, the disclosure according to any one of the above example embodiments, wherein the amplifier is configured to present a high impedance to the load output terminal and a low impedance to the measurement resistor.

In embodiments of this aspect, the disclosure according to any one of the above example embodiments, wherein a value for the measurement resistor is set to provide a desired voltage drop corresponding to an expected range of the supply current through the load.

In embodiments of this aspect, the disclosure according to any one of the above example embodiments, further comprising supplying, by an additional cascaded amplifier stage comprising an additional amplifier and an additional measurement resistor, a portion of the current to the load on a different scale from the current supplied by the measurement resistor.

In embodiments of this aspect, the disclosure according to any one of the above example embodiments, further comprising flowing the supply current through a parallel connection between the additional amplifier stage and the amplifier to increase load current capacity.

In one aspect, the present disclosure relates to a system for measuring load current, comprising a power supply, a load output terminal connected to the power supply and connected to a system ground via a load, an amplifier comprising power terminals connected to the power supply, and an output terminal connected to the system ground via a measurement resistor, the amplifier is configured to supply current from the power supply to the load via the measurement resistor and the system ground, the supply current producing a voltage across the measurement resistor that corresponds to the supply current through the load, and a processor configured to analyze the voltage across the measurement resistor to determine the load current.

In embodiments of this aspect, the disclosure according to any one of the above example embodiments, further comprising an input supply connected to a first input terminal of the amplifier, the input supply is configured to set the voltage across the load, and a feedback loop from the load to a second input terminal of the amplifier.

In embodiments of this aspect, the disclosure according to any one of the above example embodiments, wherein the supply current flows from the power supply through the power terminals of the amplifier, through the measurement resistor to the system ground, and from the system ground through the load back to the power supply.

In embodiments of this aspect, the disclosure according to any one of the above example embodiments, wherein the amplifier is configured to present a high impedance to the load output terminal and a low impedance to the measurement resistor.

In embodiments of this aspect, the disclosure according to any one of the above example embodiments, wherein the measurement resistor has a value selected to provide a desired voltage drop corresponding to an expected range of the supply current through the load.

In embodiments of this aspect, the disclosure according to any one of the above example embodiments, further comprising an additional cascaded amplifier stage comprising an additional amplifier and an additional measurement resistor, the additional measurement resistor has a different value for measuring the load current on a different scale from the measurement resistor, and the processor is further configured to analyze an additional voltage across the additional measurement resistor to determine the load current on the different scale.

The foregoing general description of the illustrative embodiments and the following detailed description thereof are merely exemplary aspects of the teachings of this disclosure and are not restrictive.

### BRIEF DESCRIPTION OF THE DRAWINGS

So that the way the above-recited features of the present disclosure can be understood in detail, a more particular description of the disclosure, briefly summarized above, may be made by reference to example embodiments, some of which are illustrated in the appended drawings. It is to be noted, however, that the appended drawings illustrate only example embodiments of this disclosure and are therefore not to be considered limiting of its scope, for the disclosure may admit to other equally effective example embodiments.
FIG. 1 illustrates a circuit diagram for a high-side current measurement system, according to aspects of the present disclosure.
FIG. 2 illustrates the high-side current measurement circuit of FIG. 1 with an additional cascaded amplifier stage, according to aspects of the present disclosure.
FIG. 3 illustrates a block diagram of a test system incorporating the current measurement circuit, according to aspects of the present disclosure.
FIG. 4 illustrates a flowchart of a method for testing a device under test using the system in FIG. 3, according to aspects of the present disclosure.

### DETAILED DESCRIPTION

The present disclosure provides an approach to high-side current measurement in electronic systems. This approach addresses the challenges associated with common-mode voltage errors, which can impact the accuracy and reliability of current measurements, particularly in high-voltage applications.

The disclosed measurement circuit features a configuration that alters the operation of a conventional amplifier. Specifically, the amplifier's output and ground connections are swapped, creating a circuit topology having increased CMRR for rejecting common-mode voltages. This arrangement may transform the amplifier's characteristics, potentially converting it from a low output impedance device to a high impedance current source. Such a transformation may be advantageous when driving loads with reactive components, such as capacitive or inductive elements. Additionally, this configuration may provide flexibility in controlling supply and output impedances, which may be leveraged to optimize stability and bandwidth for specific applications.

This configuration allows for current measurement in the high-side lead without introducing common-mode errors, thereby enhancing measurement accuracy and reliability.

The disclosed measurement circuit reduces (e.g. eliminates) common-mode errors and offers additional benefits. By reconfiguring the amplifier, the circuit transforms the amplifier's output characteristics, potentially converting a low output impedance emitter follower into a high impedance current source. Furthermore, the disclosed circuit provides flexibility in controlling supply and output impedances, which can be leveraged to optimize stability and bandwidth for specific applications.

The disclosed measurement circuit may find application in a wide range of high-voltage systems where accurate and reliable current measurement may be beneficial. These may include power management systems, battery monitoring systems, motor control systems, and other similar applications. The circuit's ability to reject common-mode voltages, coupled with its enhanced stability and bandwidth, makes it a versatile solution for these and other high-voltage applications. Moreover, the circuit's scalability, facilitated by the easy integration of multiple current stages, allows for increased load current capacity, further expanding its potential applications.

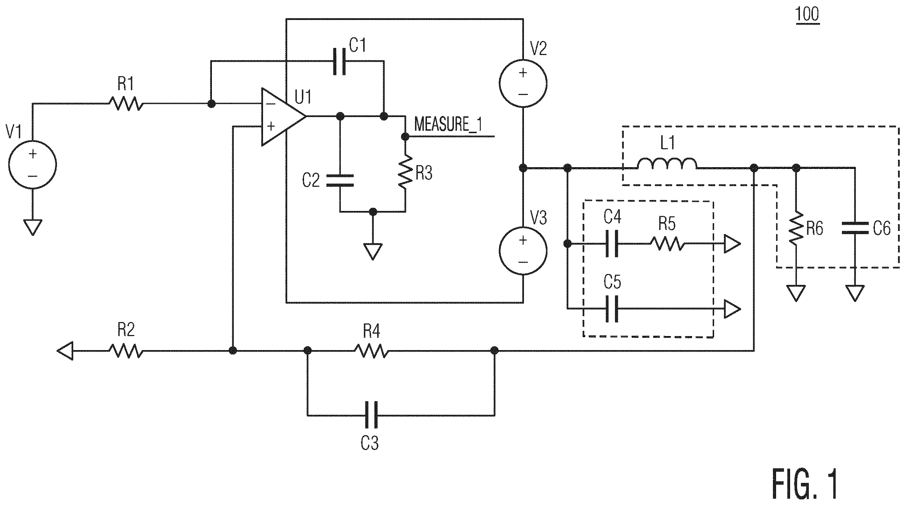

Referring to FIG. 1, a circuit diagram 100 for a high-side current measurement system is illustrated. Circuit 100 may include input resistor R1, feedback resistors R2 and R4, measurement resistor R3, power source resistor R5, load resistor R6, feedback capacitors C1 and C3, measurement capacitor C2, power source capacitors C4 and C5, load capacitor C6, load inductor L1, input voltage source V1, power sources V2 and V3, operational amplifier U1, and measurement point MEASURE_1.

The circuit presents a novel solution to eliminating common mode error by connecting the power terminals of the operational amplifier U1 to the power sources V2 and V3, and connecting the output of the operational amplifier U1 to system ground via a measurement resistor R3. This configuration forces the power sources V2 and V3 to provide load current to the load resistor R6 via a path that includes the operational amplifier U1, the measurement resistor R3, and the system ground.

More specifically, the circuit may include an input stage including voltage supply V1 and input resistor R1. The input voltage supply V1 may be controlled to set an input voltage on the inverting input terminal of operational amplifier U1. In response to this input voltage, operational amplifier U1 may cause current to flow from its power terminals through measurement resistor R3 to system ground. This current then flows from system ground through load resistor R6 and then back to power sources via to the center node between power sources V2 and V3 thereby completing the current loop. This configuration thereby uses the system ground to cause the same load current to flow through both the measurement resistor R3 and the load resistor R6.

The circuit also includes a feedback stage including resistors R2, R4 and feedback capacitor C3. Some of the load current may flow through the feedback loop of resistor R4 to system ground, which may apply a feedback voltage on the positive terminal of operational amplifier U1. This feedback mechanism may help to stabilize the operation of the circuit and improve its performance. In some aspects, the feedback loop may provide feedback to the amplifier, which may help to reduce distortion and noise in the output signal. The values of resistors R2 and R4 and capacitor C3 may be selected to optimize the feedback characteristics for the specific application. Additionally, the feedback stage may help to compensate for variations in the load or power supply, potentially enhancing the overall accuracy and reliability of the current measurement system. It is noted that in some examples, the current flowing through R4 to system ground may be eliminated by adding a buffer amplifier to the feedback path. This buffer may provide high input impedance and low output impedance, effectively isolating the feedback signal from the load current and potentially improving the accuracy of the feedback loop.

As mentioned above, the power supply stage of the circuit includes power supplies V2, V3 which may represent a transformer (e.g., push/pull transformer), capacitors C4, C5 which represent the parasitic capacitance of the transformer, and resistor R5 which represents the resistance of the transformer shield connection. The load stage of the circuit includes resistor R6 and capacitor C6 which represent the resistance and capacitance of the load, and inductor L1 which represents the inductance of the load and/or the connecting cable (not shown) to the load.

In order to determine the load current, the system may take a voltage measurement at measurement point MEASURE_1 and compute the load current based on the value of measurement resistor R3. This arrangement may allow for precise control over the test conditions, with the controller determining the target voltage and the measurement circuit managing the current supply and measurement. In some aspects, the voltage measurement at MEASURE_1 may be performed by an analog-to-digital converter (ADC) connected to the measurement circuit. The ADC may convert the analog voltage measurement to a digital value that can be processed by the controller. The controller may then use this digital value, along with the known resistance of R3, to calculate the load current. This approach may provide accurate and real-time monitoring of the load current, which can be beneficial for various testing and characterization applications. Additionally, the system may be configured to take multiple measurements over time, allowing for the analysis of dynamic load behavior or the detection of transient current events.

In some aspects, the operational amplifier U1 may be configured to present a high impedance to the load output terminal and a low impedance to the measurement resistor R3. This configuration may be advantageous for driving various types of loads, particularly those with reactive components such as capacitive or inductive elements. Furthermore, the measurement resistor R3 may have a value selected to provide a desired voltage drop corresponding to an expected range of the supply current through the load. This allows for accurate measurement of the load current across a wide range of operating conditions.

It is noted that input supply V1 may be configured to set a desired test voltage across the load resistor R6 by controlling the current flowing through U1. In some aspects, the input supply V1 may be controlled by the user or by the system to adjust the voltage across load resistor R6. The input supply may be a voltage source, such as a battery or a power supply unit. In other cases, the input supply may be a signal generator or a waveform generator capable of producing a variety of voltage waveforms, such as sinusoidal, square, triangular, or other types of waveforms. By controlling the input supply V1, the voltage across the load resistor R6 may be adjusted, thereby controlling the load current.

In some aspects, the input supply V1 may be controlled manually by a technician or automatically by the controller. Manual control may allow for direct adjustment of the voltage across load resistor R6 during testing or calibration procedures. Automatic control by the controller may enable programmed test sequences, real-time adjustments based on feedback from the measurement circuit, or dynamic voltage regulation in response to changing load conditions. This flexibility in controlling V1 may enhance the versatility of the measurement system, allowing it to adapt to various testing scenarios and requirements.

The measurement resistor R3 may have a value selected to provide a desired voltage drop corresponding to an expected range of the supply current through the load resistor R6. This allows for accurate measurement of the load current across a wide range of operating conditions. The value of the measurement resistor R3 may be selected based on the expected load current and the desired measurement resolution. In some cases, the measurement resistor R3 may be a fixed resistor with a predetermined resistance value. In other cases, the measurement resistor R3 may be a variable resistor or a set of selectable resistors, allowing for adjustment of the resistance value to accommodate different load current ranges. In either case, the value of the measurement resistor R3 may be selected based on the expected load current and the desired measurement resolution.

It is noted that in addition to its role as a measurement resistor, R3 also functions as a source resistor in the circuit. By controlling the voltage drop across R3, the operational amplifier U1 may effectively regulate the current being sourced to the load. This dual functionality of R3 may allow for precise control of the load current while simultaneously enabling accurate measurement. The value of R3 may thus be selected not only to provide an appropriate voltage drop for measurement purposes, but also to establish the desired current sourcing characteristics for the specific load requirements. This integration of measurement and current control functions in a single component may contribute to the overall efficiency and compactness of the circuit design.

Furthermore, the circuit configuration allows for control over the supply and output impedances. This can be advantageous for improving the stability of the circuit, particularly when driving reactive loads or when dealing with variations in the load or supply conditions. By controlling the supply and output impedances, the circuit can effectively manage the effects of load and supply variations, thereby maximizing stability and bandwidth.

In some cases, the circuit may include additional components or features not shown in FIG. 1. For example, the circuit may include an auxiliary power supply for providing power to the load, a temperature control system for controlling the temperature of the load during testing, or a data storage device for storing test results. The specific configuration of the circuit may vary depending on the specific requirements of the application. In some aspects, the circuit may also incorporate safety features such as overcurrent protection or voltage limiting circuits to protect both the measurement system and the device under test (DUT). Additionally, the circuit may include signal conditioning elements like filters or amplifiers to improve measurement accuracy or to adapt to different types of loads. In some implementations, the circuit may feature multiple measurement channels to allow simultaneous testing of multiple devices or different aspects of a single device. The circuit may also be designed with modularity in mind, allowing for easy expansion or reconfiguration to meet evolving testing needs. Furthermore, in some cases, the circuit may include advanced features such as self-calibration capabilities or built-in diagnostic tools to ensure measurement accuracy and system reliability over time.

Overall, the topology of circuit 100 presented in FIG. 1, where the amplifier's output and ground connections are swapped, offers several benefits for high-side current measurement applications. This innovative configuration rejects common-mode voltages, which may lead to improved measurement accuracy and reliability, particularly in high-voltage systems. By connecting the amplifier's output to system ground through a measurement resistor, the circuit may effectively isolate the measurement path from common-mode interference, potentially reducing errors that can arise from voltage fluctuations in the high-side power supply.

The circuit 100 presented in FIG. 1 may also be expanded to source different ranges of load current by incorporating additional cascaded amplifier stages. In some aspects, these additional stages may include separate amplifiers and measurement resistors, allowing for simultaneous sourcing of varying load current ranges (e.g., both small and large current ranges) which can then be measured. This expansion may enhance the versatility of the circuit, enabling it to accurately measure a wider spectrum of load currents. The additional stages may generally be connected in parallel to the main amplifier stage as will be described in detail below. Furthermore, this modular approach may allow for easy scalability, where multiple stages can be added or removed to suit specific application requirements.

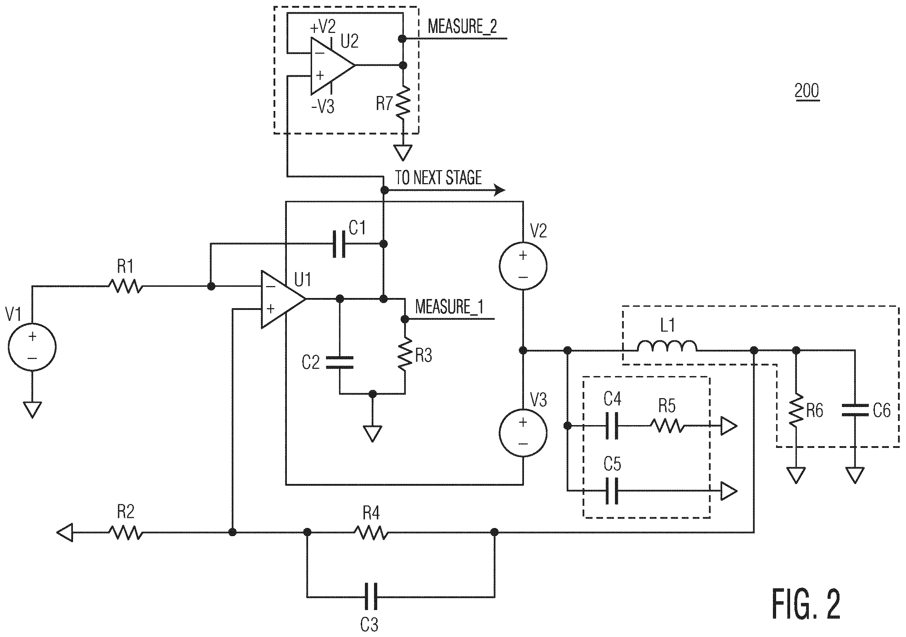

An example of circuit expansion is shown in FIG. 2 where circuit diagram 200 is illustrated. Circuit diagram 200 may include circuit 100 in FIG. 1 augmented by an additional cascaded amplifier stage which includes an additional amplifier U2 and an additional measurement resistor R7 with another measurement point MEASURE_2. This additional cascaded amplifier stage may also be connected to the same current supplies V2 and V3 as the main amplifier U1, where it serves a role in sourcing different ranges of load current. In other words, similar to the dual functionality of R3 as discussed above, R7 may have the dual functionality of a measurement resistor and a source resistor in the circuit. By controlling the voltage drop across R7, the operational amplifier U2 may effectively regulate the current being sourced to the load, while simultaneously enabling accurate measurement of the load current. The additional measurement resistor R7 may have a different resistance value from the measurement resistor R3 in the main amplifier stage. In some aspects, the resistors may also have the same value. This difference or similarity in resistance values allows the additional cascaded amplifier stage to ratio the output current between the stages, thereby controlling how much current is delivered from each stage. For instance, the main amplifier stage may be con-figured to source a larger portion of the current to the load, while the additional cascaded amplifier stage may be configured to source a smaller portion of the current to the load. This capability to ratio the output current between stages can be particularly beneficial in applications where precise control over current sourcing is desired.

In some aspects, the additional cascaded amplifier stage may be connected to the main amplifier stage. This connection may allow current from power supplies V2 and V3 to flow through both measurement resistor R3 and additional measurement resistor R7 (according to the ratio of their resistance) to load resistor R6 via system ground. Specifically, the voltage at MEASURE_1 is input to U2 which may cause current from V2 and V3 to flow through U2 and R7 thereby producing a measurement voltage on MEASURE_2. The summation of the voltages across R3 and R7 may correspond to the total load current through R6. This configuration may effectively increase the load current capacity of the circuit, which can be advantageous in applications where a high load current capacity may be desired.

In cases where measurement resistors R3 and R7 have the same resistance value, they may equally share the current flowing through the circuit. However, if R3 and R7 have different resistance values, they may share the current in proportion to their respective resistances. This configuration may allow the circuit to ratio the output current between stages. For example, if R3 has a lower resistance value compared to R7, it may handle a larger portion of the current, making it suitable for sourcing higher current ranges. Conversely, R7 with a higher resistance value may handle a smaller portion of the current, allowing it to source lower currents more precisely. This arrangement may provide flexibility in current sourcing, enabling the circuit to accommodate a wide spectrum of load currents while maintaining accuracy across different scales. In either case, the summation of voltages across R3 and R7 correspond to the load current through R6.

The configuration is not limited to the two stages as shown. In some cases, the additional cascaded amplifier stage may be duplicated a desired number of times, with each duplicate connected at a connection point labeled "TO NEXT STAGE". In other words, additional stages may branch off of the node connected to R3 in a similar manner to the stage shown in FIG. 2. For example, the connection point labeled "TO NEXT STAGE" may be connected to the input of a third amplifier U3 (not shown) for the third measurement stage (not shown). This allows for the addition of multiple additional cascaded amplifier stages, each contributing to the overall current sourcing capacity of the circuit. This scalability of the circuit can be particularly beneficial in applications where control over a wide range of load currents is desired.

As mentioned above, each stage may have the same measurement resistance or different measurement resistances that are set with respect to one another to ratio the output current. For example, in a three stage configuration, the first stage may include measurement resistor R3 with a value of 1 kΩ, the second stage may include measurement resistor R7 with a value of 100 Ω, and a third stage may include an additional measurement resistor R8 (not shown) with a value of 10 Ω. This configuration may allow the circuit to ratio the output current across three logarithmic decades. The logarithmic scaling of the current ratios may provide a wide dynamic range while maintaining good resolution across all current levels. This multi-stage logarithmic approach may be particularly useful in applications where precise control over current sourcing across several orders of magnitude is required, such as in semiconductor device testing or in power management systems with wide operating ranges.

It is noted that the logarithmic-based ratio of current sourcing in the disclosed circuit demonstrates a unique behavior where small source values produce small measurement (voltage) signals due to a small magnitude of current flowing through the larger measurement resistors, while large source values generate progressively larger measurement (voltage) signals due to an increased magnitude of current flowing through the larger measurement resistors. This configuration effectively shifts the growth in measurement signal magnitude to the larger current end of the logarithmic scale. Such an arrangement may offer advantages in applications where high precision is required for larger current measurements, while still maintaining the ability to measure smaller currents. This characteristic of the inventive circuit may be particularly beneficial in scenarios where a wide dynamic range of current measurements is needed, potentially improving the overall accuracy and resolution of the measurement system across different scales of current flow.

While the above description provides specific examples of the circuit configuration and operation, it is understood that variations to these examples are possible. For instance, the specific values of the resistors and capacitors in the circuit may be adjusted based on the specific requirements of the application. Similarly, the specific configuration of the amplifier stages and the connection of the additional cascaded amplifier stages may be varied based on the desired load current capacity and measurement range. Furthermore, additional components or features may be added to the circuit, such as additional feedback loops, voltage regulators, or protection circuits, to enhance the performance and functionality of the circuit. Despite these variations, the operation of the circuit, which involves the swapping of the output and ground connections of the amplifier to eliminate common-mode errors and improve current measurement accuracy, remains the same.

In other words, the disclosed measurement circuit provides a novel and effective solution for high-side current measurement in electronic systems. The circuit eliminates common-mode errors, enhances measurement accuracy and reliability, and offers additional benefits such as improved stability, scalability, and load-driving capabilities. The circuit's versatility and performance make it a valuable tool for a wide range of high-voltage applications, from power management systems to motor control systems and beyond.

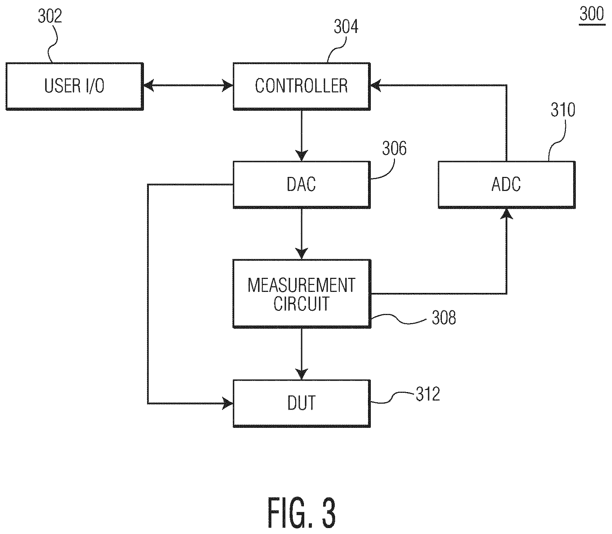

Referring to FIG. 3, a test system 300 is depicted, which may include the measurement circuit for testing a DUT 312. The test system 300 in FIG. 3 generally includes a user interface 302, controller 304, digital-to-analog converter (DAC) 306, measurement circuit 308, ADC 310, and DUT 312.

The DUT 312 may be a wide variety of electronic components, circuits, or systems that benefit from precise current measurement for testing or characterization. In some aspects, the DUT 312 may be a semiconductor device, such as an integrated circuit, microprocessor, or power transistor. In other cases, the DUT 312 may be a complete electronic module or subsystem, such as a power supply unit, battery management system, or motor controller.

For example, in some implementations, the DUT 312 may be a power semiconductor device, such as a MOSFET or IGBT, where precise characterization of on-state resistance, switching losses, and leakage currents may be beneficial. The DUT 312 may also be a complex system-on-chip (SoC) that integrates various functional blocks with different power consumption characteristics. In this case, the measurement circuit's ability to use multiple stages to source and measure both small and large currents simultaneously may be particularly beneficial for analyzing the power distribution and efficiency of different parts of the SoC.

In some aspects, the DUT 312 may be an energy harvesting device or a renewable energy system component, such as a solar cell or thermoelectric generator. For these applications, the measurement circuit's capability to measure both positive and negative currents may be beneficial for characterizing the device's performance under various environmental conditions and load scenarios.

The system may also include a user interface 302 that allows for user input and output. This user interface 302 may be a graphical user interface, a command line interface, or any other type of interface that allows a user to interact with the test system 300 to set the desired load voltages/currents. In some cases, the user interface 302 may also provide visual feedback to the user, such as displaying the current through the DUT 312 or the voltage across the DUT 312. In other words, the user interface allows the technician to perform the test and view the results.

The user interface 302 may be connected to a controller 304, which manages the overall operation of the test system 300. The controller 304 may be a microcontroller, a microprocessor, a digital signal processor, or any other type of processing device capable of controlling the operation of the test system 300. In some aspects, the controller 304 receives test commands from the user interface 302 and sends measurements back to it.

The controller 304 may be connected to a DAC 306. The controller 304 sends test voltage instructions and DUT operational instructions to the DAC 306. The DAC 306 converts these digital instructions into analog signals to set the test voltage. In some cases, the DAC 306 may be a standalone device, or it may be integrated into the controller 304 or another component of the test system 300.

The measurement circuit 308 may be connected to the DAC 306. This measurement circuit 308 receives the set test voltage from the DAC 306 and supplies the test voltage to the DUT 312. The DUT 312 may be connected to both the measurement circuit 308 and the controller 304. The controller 304 sets the desired voltage by adjusting V1 in FIG. 1, which initiates the testing process. Once the desired voltage is set, the measurement circuit 308 may begin sourcing test current to the DUT 312 via source/measurement resistors (e.g. R3, R7, etc.). This arrangement allows for precise control over the test conditions, with the controller 304 determining the target voltage and the measurement circuit 308 managing the current supply and measurement of the load.

It is noted that in addition to setting the desired voltage and initiating the testing process, the controller 304 may also control the DUT operation during the test. This control may involve sending specific commands or signals to the DUT 312 to change its operating mode, adjust its internal parameters, or trigger specific functions. For example, the controller 304 may instruct the DUT 312 to switch between different power states, execute particular operations, or simulate various load conditions. This capability allows for comprehensive testing of the DUT's performance under different operating scenarios, enabling a more thorough evaluation of its functionality and efficiency across its operating range. The controller's ability to dynamically adjust the DUT's operation during the test may also facilitate automated test sequences, where the DUT may be put through a series of predefined operational states without manual intervention.

In either case, the ADC 310 may be connected to the measurement circuit 308 and the controller 304. The ADC 310 receives DUT load measurements from the measurement circuit 308, converts these analog measurements to digital form, and sends them to the controller 304 as measurement data. In some aspects, the ADC 310 may be a standalone device, or it may be integrated into the controller 304 or another component of the test system 300.

The system may operate in a closed loop, with the controller 304 managing the test process, the DAC 306 and measurement circuit 308 applying test conditions to the DUT 312, and the ADC 310 feeding data representing measurement results back to the controller 304 for analysis and user display. This closed-loop operation allows for precise control over the test conditions and accurate measurement of the DUT load.

In some embodiments, the test system 300 may include additional components or features not shown in FIG. 3. For example, the test system 300 may include an auxiliary power supply for providing power to the DUT 312, a temperature control system for controlling the temperature of the DUT 312 during testing, or a data storage device for storing test results. The specific configuration of the test system 300 may vary depending on the specific requirements of the testing application.

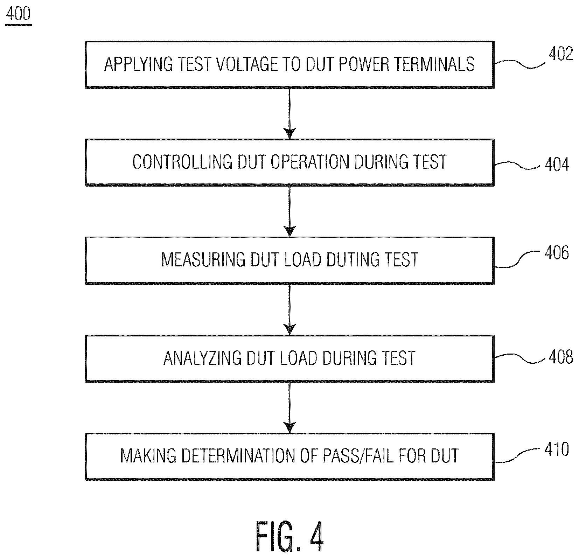

Referring to FIG. 4, a method 400 for testing DUT using the system in FIG. 3 is depicted. The method 400 in FIG. 4 includes step 402 of applying a test voltage to the DUT power terminals, step 404 of controlling DUT operation during the test, step 406 of measuring DUT load during the test, step 408 of analyzing the DUT load during the test, and step 410 of making a determination of pass/fail for the DUT.

The method 400 may begin with step 402, which involves applying a test voltage to the DUT power terminals. In some aspects, this step may be performed by a DAC 306, which receives test voltage instructions from a controller 304 and converts these digital instructions into analog signals to set the test voltage. The DAC 306 may then supply this test voltage to the DUT via a measurement circuit 308 (e.g. measurement circuit 308 is controlled to source current to the DUT).

Following this, the process moves to step 404, which may entail controlling DUT operation during the test. In some cases, this step may be performed by the controller 304, which sends DUT operational instructions to the DUT. The controller 304 may control various aspects of the DUT operation, such as the timing of the test, the sequence of operations performed by the DUT, or the parameters of the test conditions.

After controlling the DUT operation, the method 400 proceeds to step 406, where measuring DUT load during the test takes place. In some aspects, this step may be performed by the measurement circuit 308, which measures the voltage across the measurement resistor(s) and converts this voltage into a current measurement that reflects the current flowing through the DUT. The measurement circuit 308 may measure the DUT load parameters providing a comprehensive measurement of the DUT load parameters.

Step 408 may then involve analyzing the DUT load during the test. In some cases, this step may be performed by the controller 304, which receives the DUT load measurements from the measurement circuit 308 via ADC 310. The controller 304 may analyze these measurements to determine various characteristics of the DUT, such as its performance, efficiency, or reliability.

In some implementations, the analysis performed by the controller 304 may involve complex data processing techniques to extract meaningful insights from the DUT load measurements. For instance, the controller may employ statistical analysis methods to identify trends, patterns, or anomalies in the load data over time. This may include calculating average power consumption, peak current draw, or power factor for different operational modes of the DUT.

The controller 304 may also perform frequency domain analysis on the load measurements, using techniques such as Fast Fourier Transform (FFT) to identify harmonic content or noise characteristics in the DUT's power consumption. This analysis may be particularly useful for evaluating the electromagnetic compatibility (EMC) performance of the DUT or identifying potential sources of interference.

In some cases, the controller 304 may compare the analyzed data against predefined performance criteria or specifications. This comparison may involve checking if the DUT's power consumption falls within acceptable limits, if its efficiency meets target values, or if its transient response characteristics are within specified tolerances. The controller may use these comparisons to generate pass/fail criteria for the DUT or to flag potential issues for further investigation.

The analysis may also include correlation of load measurements with other test parameters, such as temperature, input voltage variations, or specific operational states of the DUT. This correlation analysis may help identify dependencies or sensitivities in the DUT's performance, providing beneficial insights for design optimization or reliability assessment.

In some implementations, the controller 304 may employ machine learning algorithms to analyze the load data. These algorithms may be trained on historical test data to recognize patterns indicative of normal operation or potential defects. This approach may enable more sophisticated anomaly detection or predictive maintenance capabilities, especially for complex DUTs with multiple operating modes or long-term reliability requirements.

The controller 304 may also generate visual representations of the analyzed data, such as graphs, charts, or heatmaps, to facilitate easier interpretation of the results. These visualizations may be displayed on the user interface 302, allowing test engineers to quickly identify trends or issues in the DUT's performance.

In some aspects, the analysis may extend beyond individual DUT performance to compare results across multiple units of the same type. This statistical analysis of a population of DUTs may help identify manufacturing variations, potential quality control issues, or opportunities for process improvement.

The depth and complexity of the analysis performed by the controller 304 may be configurable based on the specific requirements of the test application. This flexibility allows the test system to be adapted for various types of DUTs and testing scenarios, from simple go/nogo tests to detailed characterization of complex electronic systems.

Step 410 may then include making a determination of pass/fail for the DUT. This step may use the data collected and analyzed in the previous steps to assess the performance of the DUT against predetermined criteria. In some aspects, the pass/fail determination may be made by the controller 304, which may compare the DUT load measurements to a set of predefined thresholds or benchmarks to determine whether the DUT has passed or failed the test.

In some implementations, the pass/fail determination process may involve multiple criteria and complex decision-making algorithms. The controller 304 may evaluate various performance metrics simultaneously, such as power consumption, response time, output accuracy, and stability across different operating conditions. These metrics may be weighted differently based on their importance to the overall functionality of the DUT.

In some implementations, the pass/fail determination process may involve multiple criteria and complex decision-making algorithms. The controller 304 may evaluate various performance metrics simultaneously, such as power consumption, response time, output accuracy, and stability across different operating conditions. These metrics may be weighted differently based on their importance to the overall functionality of the DUT.

The pass/fail criteria may also incorporate tolerance bands or acceptable ranges for each measured parameter. For instance, a DUT might pass if its power consumption is within ±5% of the expected value, its response time is below a threshold, and its output accuracy falls within a specified range. The controller 304 may be programmed to handle different levels of compliance, potentially categorizing results as "pass," "marginal pass," or "fail" based on how closely the DUT meets the ideal specifications.

In some cases, the pass/fail determination may be adaptive, taking into account statistical variations observed across multiple units of the same DUT type. This approach may help account for normal manufacturing variations while still identifying truly defective units. The controller 304 may update its pass/fail criteria based on accumulated test data, allowing for continuous refinement of the test process.

The pass/fail determination may also consider the intended application or operating environment of the DUT. For example, a DUT destined for use in harsh industrial environments might be subject to stricter pass/fail criteria than one intended for consumer electronics. The controller 304 may be configured to apply different sets of criteria based on the specific product variant or target market of the DUT being tested.

In some implementations, the pass/fail determination may include a series of conditional checks or decision trees. For instance, if a DUT fails a beneficial parameter test, it may be immediately classified as a failure without proceeding to further tests. Conversely, marginal performance in one area might trigger additional, more detailed tests to determine the final pass/fail status.

The controller 304 may also incorporate historical data and trend analysis into the pass/fail determination. If a DUT exhibits performance characteristics that, while within acceptable limits, deviate significantly from the norm established by previously tested units, it may be flagged for additional scrutiny or classified as a "conditional pass" pending further investigation.

In some aspects, the pass/fail determination may include a confidence level or uncertainty estimate. This may be particularly useful in cases where measurement noise or variability may be a concern. The controller 304 may use statistical techniques to calculate the probability that a DUT truly meets the pass criteria, potentially flagging results with high uncertainty for manual review or retesting.

The results of the pass/fail determination may be communicated through various channels. In some implementations, the controller 304 may update the user interface 302 with a clear pass/fail indication, along with detailed test results and any relevant warnings or notes. For automated testing systems, the pass/fail result may trigger subsequent actions, such as sorting devices into appropriate bins, initiating additional tests, or updating production databases.

In some cases, the pass/fail determination may be part of a larger quality control process. The controller 304 may log test results, including pass/fail determinations, in a centralized database. This data may be used for statistical process control, identifying long-term trends in DUT performance, or triggering alerts if the pass/fail ratio falls below acceptable levels.

The pass/fail determination process may also include provisions for handling edge cases or unexpected results. The controller 304 may be programmed with decision-making algorithms to handle scenarios where DUT performance falls outside of anticipated parameters, potentially flagging these cases for human review or initiating specialized diagnostic routines.

Overall, the circuit topology 100 and 200 presented in FIGs. 1 and 2, where the amplifier's output and ground connections are swapped, offers several significant benefits for high-side current measurement applications. This innovative configuration may reject common-mode voltages, which may lead to improved measurement accuracy and reliability, particularly in high-voltage systems. By connecting the amplifier's output to system ground through a measurement resistor, the circuit may effectively isolate the measurement path from common-mode interference, potentially reducing errors that can arise from voltage fluctuations in the high-side power supply. Furthermore, this arrangement may transform the amplifier's characteristics, potentially converting it from a low output impedance device to a high impedance current source. This transformation may be particularly advantageous when driving loads with reactive components, such as capacitive or inductive elements. The high impedance output may help maintain signal integrity and reduce the impact of load variations on the measurement accuracy. Additionally, the circuit's ability to control supply and output impedances may provide flexibility in optimizing stability and bandwidth for specific applications, potentially enhancing overall system performance in various high-voltage measurement scenarios.

While the foregoing is directed to example embodiments described herein, other and further example embodiments may be devised without departing from the basic scope thereof. For example, aspects of the present disclosure may be implemented in hardware or software or a combination of hardware and software. Portions of the disclosure described herein may be implemented as a program product for use with a computer system. The program(s) of the program product defines functions of the example embodiments (including the methods described herein) and may be contained on a variety of computer-readable storage media. Illustrative computer-readable storage media include, but are not limited to: (i) non-writable storage media (e.g., read-only memory (ROM) devices within a computer, such as CD-ROM disks readably by a CD-ROM drive, flash memory, ROM chips, or any type of solid-state nonvolatile memory) on which information is permanently stored; and (ii) writable storage media (e.g., floppy disks within a diskette drive or hard-disk drive or any type of solid-state randomaccess memory) on which alterable information is stored. Such computer-readable storage media, when carrying computer-readable instructions that direct the functions of the presented example embodiments, are example embodiments of the present disclosure.

It will be appreciated by those skilled in the art that the preceding examples are exemplary and not limiting. It is intended that all permutations, enhancements, equivalents, and improvements thereto are apparent to those skilled in the art upon a reading of the specification and a study of the drawings are included within the true spirit and scope of the present disclosure. It is therefore intended that the following appended claims include all such modifications, permutations, and equivalents as fall within the true spirit and scope of these teachings.

There follows a list of numbered features defining particular embodiments of the present disclosure. Where a numbered feature refers to one or more earlier numbered features, then those features should be considered together in combination.
1. A measurement circuit, comprising:
   a power supply;
   a load output terminal connected to the power supply and connected to a system ground via a load;
   an amplifier comprising power terminals connected to the power supply, and
   an output terminal connected to the system ground via a measurement resistor, the amplifier is configured to supply current from the power supply to the load via the measurement resistor and the system ground producing a voltage across the measurement resistor that corresponds to the supply current through the load.
2. The measurement circuit of feature 1, further comprising:
   an input supply connected to a first input terminal of the amplifier, the input supply is configured to set a voltage across the load; and
   a feedback loop from the load to a second input terminal of the amplifier.
3. The measurement circuit of feature 1 or 2, wherein the supply current flows from the power supply through the power terminals of the amplifier, through the measurement resistor to the system ground, and from the system ground through the load back to the power supply.
4. The measurement circuit of any of features 1 to 3, wherein the amplifier is configured as a high impedance to the load output terminal and a low impedance to the measurement resistor.
5. The measurement circuit of any of features 1 to 4, wherein the measurement resistor has a value selected to provide a desired voltage drop corresponding to an expected range of the supply current through the load.
6. The measurement circuit of any of features 1 to 5, further comprising:
   an additional cascaded amplifier stage comprising an additional amplifier and an additional measurement resistor, the additional measurement resistor has a different value for supplying a portion of the current to the load on a different scale from the current supplied by the measurement resistor.
7. The measurement circuit of feature 6, further comprising:
   a parallel connection between the additional cascaded amplifier stage and the amplifier to increase load current capacity.
8. A method for measuring load current, comprising:
   receiving, by an amplifier, an input voltage for setting a load voltage of a load, the load comprising an output terminal connected to a power supply and connected to a system ground via the load; and
   in response to the input voltage, supplying, by the amplifier, current from the power supply to the load via power terminals of the amplifier and a measurement resistor connected to the system ground, the supply current producing a voltage across the measurement resistor that corresponds to the supply current through the load.
9. The method of feature 8, further comprising:
   feeding, via a feedback loop, a feedback signal from the load to the amplifier.
10. The method of features 8 or 9, further comprising:
   flowing the supply current from the power supply through the power terminals of the amplifier, through the measurement resistor to the system ground, and from the system ground through the load back to the power supply.
11. The method of any of features 8 to 10, wherein the amplifier is configured to present a high impedance to the load output terminal and a low impedance to the measurement resistor.
12. The method of any of features 8 to 11, wherein a value for the measurement resistor is set to provide a desired voltage drop corresponding to an expected range of the supply current through the load.
13. The method of any of features 8 to 12, further comprising:
   supplying, by an additional cascaded amplifier stage comprising an additional amplifier and an additional measurement resistor, a portion of the current to the load on a different scale from the current supplied by the measurement resistor.
14. The method of feature 13, further comprising:
   flowing the supply current through a parallel connection between the additional amplifier stage and the amplifier to increase load current capacity.
15. A system for measuring load current, comprising:
   a power supply;
   a load output terminal connected to the power supply and connected to a system ground via a load;
   an amplifier comprising power terminals connected to the power supply, and an output terminal connected to the system ground via a measurement resistor, the amplifier is configured to supply current from the power supply to the load via the measurement resistor and the system ground, the supply current producing a voltage across the measurement resistor that corresponds to the supply current through the load; and
   a processor configured to analyze the voltage across the measurement resistor to determine the load current.
16. The system of feature 15, further comprising:
   an input supply connected to a first input terminal of the amplifier, the input supply is configured to set the voltage across the load; and
   a feedback loop from the load to a second input terminal of the amplifier.
17. The system of features 15 or 16, wherein the supply current flows from the power supply through the power terminals of the amplifier, through the measurement resistor to the system ground, and from the system ground through the load back to the power supply.
18. The system of any of features 15 to 17, wherein the amplifier is configured to present a high impedance to the load output terminal and a low impedance to the measurement resistor.
19. The system of any of features 15 to 18, wherein the measurement resistor has a value selected to provide a desired voltage drop corresponding to an expected range of the supply current through the load.
20. The system of any of features 15 to 19, further comprising:
   an additional cascaded amplifier stage comprising an additional amplifier and an additional measurement resistor, the additional measurement resistor has a different value for supplying a portion of the load current on a different scale from the current supplied by the measurement resistor, and the processor is further configured to analyze an additional voltage across the additional measurement resistor to determine the load current.

## Claims

1. A measurement circuit, comprising:
a power supply;
a load output terminal connected to the power supply and connected to a system ground via a load;
an amplifier comprising power terminals connected to the power supply, and
an output terminal connected to the system ground via a measurement resistor, the amplifier is configured to supply current from the power supply to the load via the measurement resistor and the system ground thereby producing a voltage across the measurement resistor that corresponds to the supply current through the load.

2. The measurement circuit of claim 1, further comprising:
an input supply connected to a first input terminal of the amplifier, the input supply is configured to set a voltage across the load; and
a feedback loop from the load to a second input terminal of the amplifier.

3. The measurement circuit of claims 1 or 2, wherein the supply current flows from the power supply through the power terminals of the amplifier, through the measurement resistor to the system ground, and from the system ground through the load back to the power supply.

4. The measurement circuit of any of claims 1 to 3, wherein the amplifier is configured as a high impedance to the load output terminal and a low impedance to the measurement resistor.

5. The measurement circuit of any of claims 1 to 4, wherein the measurement resistor has a value selected to provide a desired voltage drop corresponding to an expected range of the supply current through the load.

6. The measurement circuit of any of claims 1 to 5, further comprising:
an additional cascaded amplifier stage comprising an additional amplifier and an additional measurement resistor, the additional measurement resistor has a different value for supplying a portion of the current to the load on a different scale from the current supplied by the measurement resistor.

7. The measurement circuit of claim 6, further comprising:
a parallel connection between the additional cascaded amplifier stage and the amplifier to increase load current capacity.

8. A system for measuring load current, comprising:
a measurement circuit according to any of the preceding claims, and
a processor configured to analyze the voltage across the measurement resistor to determine the load current.

9. A system according claim 8 when dependent on claims 6 or 7, wherein the processor is further configured to analyze an additional voltage across the additional measurement resistor to determine the load current.

10. A method for measuring load current, comprising:
receiving, by an amplifier, an input voltage for setting a load voltage of a load, the load comprising an output terminal connected to a power supply and connected to a system ground via the load; and
in response to the input voltage, supplying, by the amplifier, current from the power supply to the load via power terminals of the amplifier and a measurement resistor connected to the system ground, the supply current producing a voltage across the measurement resistor that corresponds to the supply current through the load.

11. The method of claim 8, further comprising:
feeding, via a feedback loop, a feedback signal from the load to the amplifier.

12. The method of claim 8, further comprising:
flowing the supply current from the power supply through the power terminals of the amplifier, through the measurement resistor to the system ground, and from the system ground through the load back to the power supply.

13. The method of claim 8, wherein the amplifier is configured to present a high impedance to the load output terminal and a low impedance to the measurement resistor.

14. The method of claim 8, wherein a value for the measurement resistor is set to provide a desired voltage drop corresponding to an expected range of the supply current through the load.

15. The method of claim 8, further comprising:
supplying, by an additional cascaded amplifier stage comprising an additional amplifier and an additional measurement resistor, a portion of the current to the load on a different scale from the current supplied by the measurement resistor;
and optionally further comprising:
flowing the supply current through a parallel connection between the additional amplifier stage and the amplifier to increase load current capacity.
